# EUROPÄISCHE PATENTSCHRIFT

(11) **EP 3 410 494 B1**
(45) Veröffentlichungstag und Bekanntmachung des Hinweises auf die Patenterteilung: **09.10.2019**
(21) Anmeldenummer: 17173259.7
(22) Anmeldetag: 29.05.2017
(51) Int. Cl.: H01L 31/05

(54) **PHOTOVOLTAISCHE ZELLE UND MODULE SOWIE VERFAHREN ZU DEREN HERSTELLUNG**
PHOTOVOLTAIC CELL AND MODULES AND METHOD FOR THEIR PREPARATION
CELLULE PHOTOVOLTAÏQUE ET PANNEAU ET LEUR PROCÉDÉ DE PRODUCTION

(43) Veröffentlichungstag der Anmeldung: 05.12.2018
(73) Patentinhaber: Sefar AG, 9410 Heiden (CH)
(72) Erfinder: Chabrecek, Peter, 9403 Goldach (CH); Sonderegger, Uriel, 9424 Rheineck (CH); Steim, Roland, 8600 Dübendorf (CH)
(74) Vertreter: Wunderlich & Heim Patentanwälte Partnerschaftsgesellschaft mbB

(56) Entgegenhaltungen:
- EP-A1- 2 660 878
- WO-A1-2016/156276
- DE-A1-102011 050 250
- JP-A- 2006 165 149
- US-A- 3 255 047

## Beschreibung

Die Erfindung betrifft ein Verfahren zum Herstellen einer photovoltaischen Zelle wie auch eines neuen Photovoltaik-Moduls mit einem photoelektrisch wirksamen Flächenelement und mindestens einer Leiterbahnanordnung an mindestens einer Oberflächenseite des Flächenelements, gemäß dem Oberbegriff des Anspruchs 1.

Die Erfindung betrifft weiterhin eine photovoltaische Zelle mit mindestens einem photoelektrisch wirksamen Flächenelement und mindestens einer Leiterbahnanordnung an mindestens einer Oberflächenseite des Flächenelements, gemäß dem Oberbegriff des Anspruchs 15.

Solarzellen verschiedenster Bauart, insbesondere sogenannte Dickschicht- oder Dünnschicht-Solarzellen, sind seit langem bekannt. Solarzellen weisen ein photoelektrisch wirksames Flächenelement auf, welches üblicherweise unter Verwendung eines oder mehrerer Halbleitermaterialien, insbesondere von Silizium, gebildet ist. Auf das Flächenelement auftreffendes Licht erzeugt in dem schichtartig aufgebauten Flächenelement freie Ladungsträger. Durch eine entsprechende Lenkung der so erzeugten freien Ladungsträger kann eine Spannung erzeugt werden, welche zur Erzeugung von Strom genutzt werden kann.

Zur Stromerzeugung ist es bei einer Vielzahl von Typen von Solarzellen erforderlich, unmittelbar auf der photoelektrisch wirksamen Oberflächenseite, auf welcher das Licht auftrifft, eine elektrische Leiterbahnanordnung aufzubringen, insbesondere aufzudrucken. Mit zunehmender Größe der Leiterbahnanordnung erhöht sich auch die sogenannte Abschattung, was zu einer Reduzierung der photoelektrisch wirksamen Oberfläche und somit der Leistungsausbeute einer Solarzelle führt.

Es besteht ein erheblicher Bedarf an Solarzellen mit verbesserter Leistungsausbeute, also mit einem erhöhten Wirkungsgrad. Darüber hinaus werden am Markt immer kostengünstigere Solarzellen gefordert, damit diese möglichst breite Anwendung finden können.

Es ist bekannt, die Leiterbahnanordung auf einer Folie auszubilden, etwa aufzudrucken, und diese dann als ein elektrisch leitfähiges Substrat auf das photovoltaische Flächenelement aufzubringen.

Aus der EP 2 790 196 A1 geht elektrisch leitfähiges Substrat für eine optoelektronische Vorrichtung hervor, bei welcher eine Leiterbahnanordnung durch Verweben von metallischen oder metallisierten Fasern hergestellt wird. Dabei wird das Gewebe mit einer teil- oder ganzflächigen Beschichtung derart versehen, dass ein Teilbereich des Gewebes freiliegt und zur Kontaktierung mit einer optoelektronischen Vorrichtung eingesetzt werden kann.

Ein ähnliches Substrat für eine optoelektronische Vorrichtung ist auch aus der DE 10 2008 055 969 A1 bekannt. Auf derartigen Substraten kann ein photoelektrisch wirksames Flächenelement zum Bilden einer photovoltaischen Zelle aufgebracht werden. Dabei muss jedoch weiterhin eine gute elektrische Kontaktierung mit der Oberfläche des photoelektrisch wirksamen Flächenelementes hergestellt werden. Dies ist mit einem zusätzlichen Aufwand verbunden und kann zu einer Herabsetzung des Wirkungsgrades führen.

Ein gattungsgemäßes Verfahren geht aus der WO 2016/156 276 A1 hervor. Es wird eine gewebte Leiterbahnanordnung mit aufschmelzbaren Polymerfäden eingesetzt. Diese werden durch eine Wärmebehandlung verflüssigt, um eine Hüllschicht zu bilden.

Aus der EP 2 660 878 A1 und der US 3,255,047 A ist es bekannt, ein Gewebe mit einer elektrischen Leiterbahnanordnung mittels elektrischer Kontaktpunkte aus einer Lötpaste zu fixieren.

Die JP 2006 165 149 A1 lehrt eine Fixierung einer gewebten Leiterbahnanordnung mittels einer zusätzlichen Haftschicht.

Der Erfindung liegt die **Aufgabe** zugrunde, eine photovoltaische Zelle und ein Verfahren zu deren Herstellung anzugeben, mit welchen eine photovoltaische Zelle mit besonders gutem Wirkungsgrad sowie ein Verfahren zu einem effizienten Herstellen einer derartigen photovoltaischen Zelle wie auch eines neuen Photovoltaik-Moduls erreicht wird.

Die Aufgabe wird nach der Erfindung durch ein Verfahren mit den Merkmalen des Anspruchs 1 und einer photovoltaischen Zelle mit den Merkmalen des Anspruchs 15 gelöst. Bevorzugte Ausführungsformen der Erfindung sind in den abhängigen Ansprüchen angegeben.

Bei dem erfindungsgemäßen Verfahren ist vorgesehen, dass zum Bilden der Leiterbahnanordnung auf die mindestens eine Oberflächenseite des photoelektrisch wirksamen Flächenelements ein offenes Gewebe aufgebracht wird, welches aus elektrisch leitenden Fäden und transparenten, elektrisch nicht-leitenden Fäden gewebt ist, wobei das offene Gewebe frei von einer flächigen Beschichtung ist.

Eine Grundidee der Erfindung besteht darin, zum Bilden der Leiterbahnanordnung auf einer Oberflächenseite eines photoelektrisch wirksamen Flächenelementes ein offenes Gewebe, also ein unbeschichtetes Gewebe, einzusetzen. Das Gewebe wird dabei direkt auf die Oberflächenseite des photoelektrisch wirksamen Flächenelementes aufgebracht. Hierdurch kann der Arbeitsschritt des Herstellens eines Substrates mit einer durchgehenden Beschichtung, wie es aus dem Stand der Technik bekannt ist, entfallen. Das Gewebe ist sehr einfach aufgebaut, was aufgrund der offenen Struktur und der Verwendung transparenter nicht-leitender Fäden zu einer guten Lichtdurchlässigkeit und damit zu einer guten Energieausbeute des photoelektrisch wirksamen Flächenelementes führt. Das Gewebe kann vorzugsweise auf der dem Licht ausgesetzten Vorderseite oder beiden Oberflächenseiten angeordnet sein. Bei neueren IBC SHJ-Solarzellen kann das Gewebe auch nur an der Rückseite des Flächenelements angebracht sein.

Nach der Erfindung ist vorgesehen, dass das offene Gewebe zumindest teilweise mit aufschmelzbaren Fäden gebildet wird und dass nach dem Aufbringen des offenen Gewebes eine Wärmebehandlung erfolgt, bei der die aufschmelzbaren Fäden zumindest teilweise aufgeschmolzen werden, wobei das offene Gewebe mit den aufgeschmolzenen Fäden fest mit dem Flächenelement verbunden wird. Nach einem Aufbringen des Gewebes kann dieses so einfach auf der Oberflächenseite des Flächenelementes fixiert werden. Dabei können zumindest ein Teil der im Gewebe verwendeten Fäden zumindest an ihrem Oberflächenbereich aufschmelzen. Das aufgeschmolzene Material stellt dabei eine innige Verbindung zu der Oberfläche des Flächenelementes dar, wobei das Gewebe zumindest bereichsweise zuverlässig an der Oberflächenseite des Flächenelementes anhaftet.

Gemäß der Erfindung sind die nicht-leitenden Fäden mit einem thermoplastischen Polymermaterial, insbesondere einem thermoplastischen Olefin, gebildet, welche teilweise aufschmelzen. Das thermoplastische Polymermaterial kann insbesondere PP, POE, PA, PET, PEN oder andere umfassen. Die Polymerfäden sind transparent.

Grundsätzlich können nur die nicht-leitenden Fäden aufgeschmolzen werden. Eine bevorzugte Weiterbildung der Erfindung besteht jedoch darin, dass die elektrisch leitenden Fäden aus einem Metall oder einer Metalllegierung mit einer niedrigen Schmelz- oder Erweichungstemperatur, insbesondere von unter 200 °C gebildet sind und zumindest teilweise aufschmelzen. Somit können also nur die elektrisch leitenden Fäden oder sowohl die leitenden und nicht-leitenden Fäden bei der Wärmebehandlung aufschmelzen. Dies führt zu einer besonders innigen Verbindung mit der Oberfläche des Flächenelementes. Das Aufschmelzen der metallischen leitenden Fäden führt auch zu einer verbesserten Kontaktierung und damit Verringerung des inneren Widerstandes der photovoltaischen Zelle. Die metallischen Fäden können ein Vollmaterial aufweisen oder sind mit einer aufschmelzbaren metallischen Beschichtung versehen. Ein aufschmelzbares Material kann eine Legierung aus Cu/lnSn, Cu/Sn, CU/SBA oder andere sein. Vorzugsweise kann eine Zinnlegierung (Sn-Legierung) durch Feuerverzinnen aufgebracht sein.

Besonders vorteilhaft ist es nach einer Weiterbildung der Erfindung, dass Fäden unmittelbar in Kontakt mit der Oberfläche des Flächenelementes kommen und beim Aufschmelzen sich eine Kontaktfläche der Fäden zur Oberfläche des Flächenelements vergrößert. Insbesondere bei der Verwendung aufschmelzbarer leitender Fäden kann so eine Kontaktfläche zu dem Flächenelement vergrößert und besonders innig ausgeführt werden. Dies erlaubt einen besonders widerstandsarmen Spannungs- oder Stromabgriff.

Die Wärmebehandlung kann mit einer geeigneten Temperatur durchgeführt werden. Besonders bevorzugt ist es nach einer Weiterbildung der Erfindung, dass bei der Wärmebehandlung eine Temperatur von 250 °C, insbesondere von 200 °C, nicht überschritten wird. Vorzugsweise liegt die Temperatur der Wärmebehandlung zwischen 140 °C und 200 °C. Bei dieser relativ geringen Temperatur wird eine thermische Schädigung des empfindlichen Flächenelementes aus dem Halbleitermaterial vermieden. Somit ist insbesondere das erfindungsgemäße Verfahren zur Herstellung neuerer Solarzellen aus besonders thermisch empfindlichen Materialien, insbesondere von Silizium-Heterostruktur-Solarzellen, besonders geeignet.

Durch die thermische Wärmebehandlung kann das offene Gewebe auf dem Flächenelement hinreichend positioniert und fixiert sein. Für eine stabile Befestigung ist es nach einer Ausführungsvariante der Erfindung vorgesehen, dass nach dem Aufbringen des offenen Gewebes eine Verbindungsmasse auf das Flächenelement laminiert wird. Die Verbindungsmasse ist dabei transparent, so dass weiterhin eine gute Lichtdurchlässigkeit gegeben ist. Insbesondere kann die Verbindungsmasse ein thermisches Polymer oder ein UV aushärtbares Polymer oder Polymermischung sein, wie es etwa für die Verwendung der elektrisch nicht-leitenden Fäden oder ein Fluoropolymer, oder Silicone vorgesehen ist.

Erfindungsgemäß wird nach dem Aufbringen des offenen Gewebes eine transparente Deckschicht, insbesondere ein Glas, auf das Flächenelement aufgebracht. Die transparente Deckschicht kann mit oder ohne die Verbindungsmasse vorgesehen werden. Vorzugsweise ist jedoch die transparente Deckschicht mit der Verbindungsmasse auf die Oberflächenseite des Flächenelementes mit dem offenen Gewebe aufgebracht. Hierdurch wird ein besonders guter Schutz und eine besonders robuste Oberfläche der photovoltaischen Zelle erreicht.

Weiterhin ist es nach der Erfindung bevorzugt, dass das offene Gewebe eine Kontaktseite aufweist, entlang welcher ein wesentlicher Teil der elektrisch leitenden Fäden verläuft. Insbesondere kann das Gewebe mit einer Köperbindung versehen sein, insbesondere mit einer Köperbindung von 5:1 oder 3:1 gewebt sein. Auch Köperbindungen von bis zu 11:1 oder höher sind möglich, wobei die elektrisch leitenden Fäden an der Kontaktseite des offenen Gewebes mehrere angrenzende Fäden überlaufen und so einen besonders großen Kontaktbereich bilden.

Grundsätzlich können auch andere geeignete Gewebe und Bindesysteme vorgesehen sein. Besonders vorteilhaft ist es nach einer Weiterbildung der Erfindung, dass in dem offenen Gewebe die elektrisch leitenden Fäden in Schuss- und/oder Kettrichtung verwebt werden. Bei einem Verweben nur in Schuss- oder in Kettrichtung werden elektrische Leiterbahnen geschaffen, welche im Wesentlichen parallel verlaufen. Durch ein Verweben von elektrisch leitenden Fäden in Schuss- und in Kettrichtung kann eine raster- oder gitterartige Leiterbahnanordnung in dem offenen Gewebe geschaffen werden. Dies kann für bestimmte Solarzellenanordnungen vorteilhaft sein.

Grundsätzlich kann das photoelektrisch wirksame Flächenelement jedes optoelektrische oder optoelektronische Element sein, welches vorzugsweise Lichtenergie in elektrische Energie umwandelt. Dabei kann jeder übliche Aufbau für eine Solarzelle vorgesehen sein, insbesondere sogenannte Al-BSF, PERC-/PERT-/PERL-Zellen oder sonstige Solarzellen. Eine besonders vorteilhafte Weiterbildung des erfindungsgemäßen Verfahrens besteht darin, dass als photoelektrisch wirksames Flächenelement eine Silizium-Heterostruktur-Solarzelle, auch SHJ-Solarzelle genannt, vorgesehen ist. Derartige Solarzellen stellen eine neuere Generation von Solarzellen dar und besitzen einen erhöhten Wirkungsgrad. Derartige Solarzellen sind besonders wärmeempfindlich.

Nach einer Weiterbildung der Erfindung ist vorgesehen, dass die Leiterbahnanordnung mit dem offenen Gewebe einseitig oder zweiseitig auf das Flächenelement aufgebracht wird. Insbesondere bei einer einseitigen Aufbringung kann die Leiterbahnanordnung an der dem Licht ausgesetzten Oberflächenseite des Flächenelementes vorgesehen sein. In gleicher Weise kann auch an der Unterseite des Flächenelementes eine zweite Leiterbahnanordnung angeordnet sein, insbesondere bei sogenannten bifacialen Zellen.Vorzugsweise bei neueren IBC SHJ-Solarzellen kann das Gewebe mit der Leiterbahnanordnung auch nur auf der dem Licht abgewandten Unter- oder Rückseite angebracht sein.

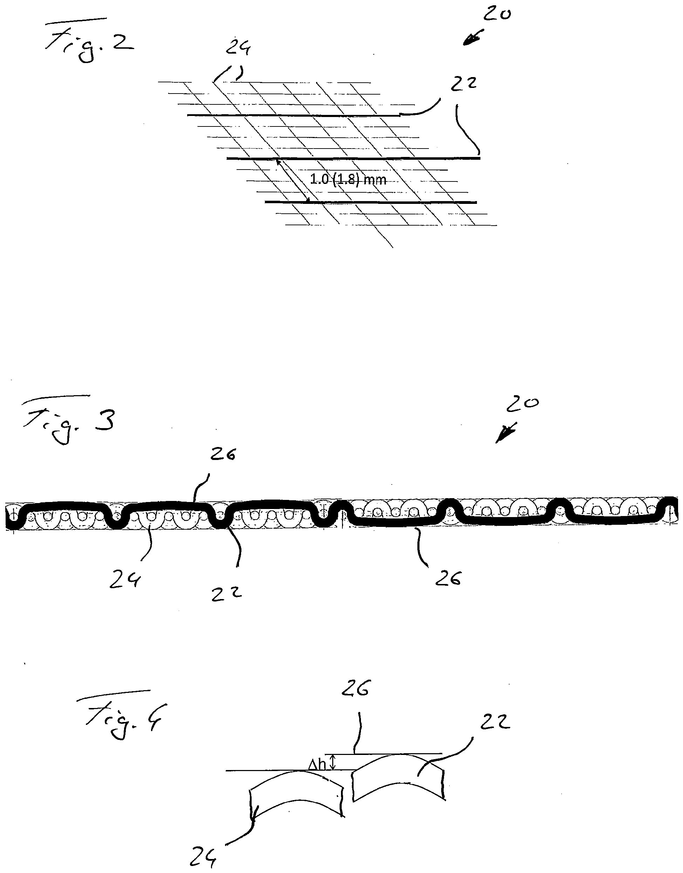

Für eine besonders zweckmäßige Verbindung zu einem photovoltaischen Modul ist es nach einer erfindungsgemäßen Verfahrensvariante bevorzugt, dass mehrere Flächenelemente über ein oder mehrere Gewebe zu einem photovoltaischen Modul verbunden werden. Dabei kann das offene Gewebe mehrfach so groß sein wie eine einfache photovoltaische Zelle.Dabei können die elektrisch leitenden Fäden nur auf einer Seite des Gewebes laufen oder bevorzugt alternativ, erst auf einer dann auf anderer Seite des Gewebes (Fig.3). Solche Gewebe mit alternativ leitenden Kontaktseiten ist besonders für die Z-Verschaltung der Zellen in einem Modul sehr gefragt. Das offene Gewebe kann mehrere aneinander angrenzende Photozellen kontaktierten und miteinander verbinden. Dies kann an einer Oberflächenseite sein oder wechselweise zwischen einer Vorder- und einer Rückseite der angrenzenden Zellen. Dabei stellt das offene Gewebe nicht nur eine leitende elektrische Verbindung zwischen aneinander angrenzende Solarzellen dar, sondern verbindet diese auch in mechanischer Weise.

Hinsichtlich einer photovoltaischen Zelle ist die eingangs genannte Aufgabe noch dadurch gelöst, dass zum Bilden der Leiterbahnanordnung auf der mindestens einen Oberflächenseite des Flächenelementes direkt ein offenes Gewebe aufgebracht ist, welches aus elektrisch leitenden Fäden und transparenten, elektrisch nicht-leitenden Fäden gewebt ist. Die photovoltaische Zelle ist insbesondere nach einem der zuvor beschriebenen Verfahren hergestellt, wobei sich auch die entsprechenden Vorteile ergeben.

Darüber hinaus ist nach der Erfindung ebenfalls ein Gewebe vorgesehen, welches dadurch gekennzeichnet ist, dass dieses ein offenes Gewebe ist, welches aus elektrisch leitenden Fäden und transparenten, elektrisch nicht-leitenden Fäden gewebt ist, und dass zumindest ein Teil der Fäden bei einer Temperatur von unter 200 °C aufschmelzbar ist. Das Gewebe ist insbesondere für die zuvor beschriebene photovoltaische Zelle oder für das zuvor beschriebene Verfahren nach der Erfindung einsetzbar.

Erfindungsgemäß ist zum Bilden des Gewebes als elektrisch leitender Faden ein Draht aus einem leitenden Metall oder mit einer leitenden Metallbeschichtung mit einem Durchmesser zwischen 70 µm und 300 µm vorgesehen. Der elektrisch nicht-leitende Faden weist einen Durchmesser zwischen 30 µm und 70 µm auf. Er ist aus einem transparenten Polymermaterial gefertigt, insbesondere PEN, PP, POE und PA oder PET mit einer Transparenz von 95% und größer, insbesondere größer 99%. Die Fadenzahl in Kettrichtung beträgt vorzugsweise 40 bis 60 Fäden pro cm und in Schussrichtung ebenso 40 bis 60 Fäden pro cm. Dabei ist das Gewebe maßgeblich aus den nicht-leitenden, transparenten Fäden gebildet, wobei die elektrisch leitenden Fäden in einem Abstand zwischen 0,5 mm und 15 mm, vorzugsweise zwischen 1 mm und 8 mm vorgesehen sind. Als Bindung ist insbesondere eine Köperbindung, vorzugsweise von 5/1 bis 11/1 oder 3/3 vorgesehen.

Erfindungsgemäß stehen die elektrisch leitenden Fäden gegenüber den nicht-leitenden Fäden um einen definierten Betrag nach außen vor, wobei der Betrag vorzugsweise zwischen 10 bis 20 µm beträgt. Hierdurch kann ein verbesserter Kontakt der elektrisch leitenden Fäden zu der Oberflächenseite des Flächenelementes erreicht werden. Die Dicke des Gewebes beträgt vorzugsweise zwischen 100 µm bis 400 µm.

Nachfolgend wird die Erfindung weiter anhand von bevorzugten Ausführungsbeispielen beschrieben, welche schematisch in den Zeichnungen dargestellt sind. In den Zeichnungen zeigen:
- Fig. 1: einen Aufbau einer erfindungsgemäß hergestellten photovoltaischen Zelle;
- Fig. 2: eine Ansicht eines Gewebes für die erfindungsgemäße photovoltaische Zelle;
- Fig. 3: eine vergrößerte Querschnittsansicht durch ein Gewebe für die Erfindung;
- Fig. 4: eine schematische Querschnittsansicht zum Aufbau eines Gewebes für die Erfindung;
- Fig. 5: eine erste Verbinderanordnung zum Verbinden mehrerer photovoltaischen Zellen mit einem Gewebe; und
- Fig. 6: eine zweite Verbinderanordnung zum Verbinden photovoltaischer Zellen.

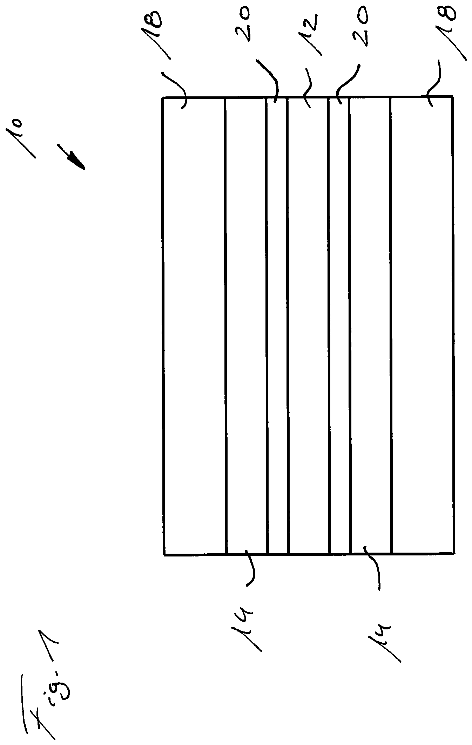

Eine erfindungsgemäße photovoltaische Zelle ist in Fig. 1 dargestellt. Diese weist als einen wesentlichen Teil ein photoelektrisch wirksames Flächenelement 12 auf. Das Flächenelement 12 ist in bekannter Weise aus einem Halbleitermaterial, insbesondere einem Siliziummaterial, in einer Schichtstruktur gebildet, wobei beim Auftreffen von Lichtenergie Ladungsträger verschoben werden. Das Flächenelement 12 kann insbesondere eine Silizium-Heterostruktur-Solarzelle sein.

Um an den beiden Oberflächenseiten des Flächenelementes 12 elektrische Ladungsträger oder eine Spannung abzugreifen, ist gemäß der Erfindung jeweils ein offenes Gewebe 20 aufgebracht. Das Gewebe 20 weist gemäß Fig. 2 nicht-leitende Fäden 24 und elektrisch leitende Fäden 22 auf, welche eine Leiterbahnanordnung bilden.

Nach dem Aufbringen oder Auflegen des offenen Gewebes 20 erfolgt eine Wärmebehandlung in einem Temperaturbereich von vorzugsweise zwischen 140° C und 180° C. Hierbei schmelzen sowohl die leitenden Fäden 22 und die nicht-leitenden Fäden 24 des Gewebes 20 auf und bilden eine vergrößerte Kontaktfläche und eine feste Verbindung zur Oberfläche des Flächenelementes 12.

Anschließend wird eine Verbindungsmasse 14, insbesondere aus einem Kunststoff- oder Klebematerial, in einem aufgeschmolzenen oder fließfähigen Zustand auflaminiert. Abschließend wird eine Deckschicht 18 oder ein UV stabiles Polymer, wie Teflon oder Silicon, insbesondere ein Glas, zu beiden Seiten des Flächenelementes 12 auf die Verbindungsmasse 14 aufgebracht. Mit Aushärten der Verbindungsmasse 14 ist die Deckschicht 18, insbesondere ein durchsichtiges Glasmaterial, fest verbunden, so dass hierdurch eine robuste äußere Schutzschicht für die photovoltaische Zelle 10 gegeben ist.

Ein erfindungsgemäßes offenes Gewebe 20 ist aus elektrisch leitenden Fäden 22 und elektrisch nicht-leitenden Fäden 24 aus einem Polymermaterial gewebt. Bei dem erfindungsgemäßen offenen Gewebe 20 ist keine durchgehende Beschichtung oder sonstige Schichtauflage vorgesehen, so dass weiterhin die Freiräume und Durchgänge durch die Gewebestruktur bestehen. Bei dem dargestellten Gewebe 20 sind die elektrisch leitenden Fäden 22 als metallische Drähte mit einem Abstand von 1 mm bis 1,8 mm zueinander verwebt. Als Kettfäden sowie dazwischenliegende Schussfäden sind nicht-leitende Fäden 24 aus einem transparenten und thermoplastischen Olefin vorgesehen. In Kett- und in Schussrichtung sind insgesamt 60 Fäden 22, 24 pro cm verwebt.

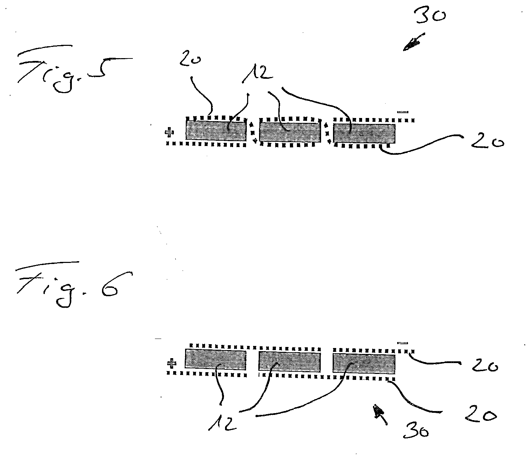

Eine mögliche Gewebebindung mit einem Köper 5:1 ist in Fig. 3 dargestellt. Dabei übergreift ein elektrisch leitender Faden 22 in Schussrichtung jeweils fünf elektrisch nicht-leitende Kettfäden 24, bevor eine Fadenumschlingung ausgebildet ist. Hierbei ergeben sich längliche und damit großflächige Kontaktbereiche des elektrisch leitenden Fadens 22 an einer Kontaktseite 26 des Gewebes 20. Das Gewebe 20 gemäß Fig. 3 weist dabei die Besonderheit auf, dass beide Seiten als Kontaktseiten 26 ausgebildet sind, wobei die Köperbindung an vorgegebenen Stellen von einer Kontaktseite 26 zur anderen Kontaktseite 26 wechselt. Diese wechselnde Anordnung bei einem Gewebe 20 ist insbesondere für ein photovoltaisches Modul 30 mit mehreren Flächenelementen 12 vorteilhaft, wie es in Fig. 5 dargestellt ist. Dabei werden die Vorder- und Rückseiten der Flächenelemente 12, welche aneinander grenzen, jeweils abwechselnd von einem durchgehenden Gewebe 20 umschlungen, so dass jeweils wechselnde Kontaktbereiche notwendig sind.

Es kann jedoch auch ein erfindungsgemäßes Gewebe 20 mit nur einer Kontaktseite 26 ausgebildet sein, bei welcher die elektrisch leitenden Fäden 22 im Wesentlichen an der einen Kontaktseite 26 entlang verlaufen. Eine derartige Gewebeausbildung ist insbesondere für ein photovoltaisches Modul 30 gemäß Fig. 6 geeignet, bei welchem jeweils ein Gewebe 20 an je einer Seite einer Anordnung aus einer Mehrzahl von Flächenelementen 12 angebracht sind. Nach der Kontaktierung durch das oder die Gewebe 20 können die Verbindungsmasse 14 und die Deckschicht 18 aufgetragen werden.

Bei der Ausbildung eines erfindungsgemäßen Gewebes 20 ist es insbesondere an der Kontaktseite 26 sinnvoll und vorteilhaft, wenn die leitenden Fäden 22 gegenüber den benachbarten nicht-leitenden Fäden 24 um einen definierten Betrag Δh nach außen vorstehen, wie anschaulich Fig. 4 dargestellt ist. Dieser Betrag des Vorsprungs der elektrisch leitenden Fäden 22 beträgt insbesondere zwischen 10 µm und 50 µm.

## Patentansprüche

1. Verfahren zum Herstellen einer photovoltaischen Zelle (10) mit
- einem photoelektrisch wirksamen Flächenelement (12) und
- mindestens einer Leiterbahnanordnung an mindestens einer Oberflächenseite des Flächenelementes (12),
wobei
zum Bilden der Leiterbahnanordnung auf die mindestens eine Oberflächenseite des photoelektrisch wirksamen Flächenelementes (12) ein offenes Gewebe (20) aufgebracht wird, welches aus elektrisch leitenden Fäden (22) und transparenten, elektrisch nicht leitenden Fäden (24) gewebt ist, wobei das offene Gewebe (20) frei von einer flächigen Beschichtung ist, und
das offene Gewebe (20) zumindest teilweise mit aufschmelzbaren Fäden (22, 24) gebildet wird,
wobei die elektrischen nicht leitenden Fäden (24) mit einem thermoplastischen Polymermaterial gebildet sind,
wobei nach dem Aufbringen des offenen Gewebes (20) eine Wärmebehandlung erfolgt, bei der die aufschmelzbaren Fäden (22, 24) teilweise aufgeschmolzen werden,
wobei das offene Gewebe (20) mit den teilweise aufgeschmolzenen Fäden (22, 24) fest mit dem Flächenelement (12) verbunden und daran fixiert wird, und auf das fixierte offene Gewebe (20) eine transparente Deckschicht (18) aufgebracht wird,
**dadurch gekennzeichnet,**
**dass** die elektrisch nicht leitenden Fäden (24) einen Durchmesser von 30 µm bis 70 µm und die elektrisch leitenden Fäden (22) einen Durchmesser von 70 µm bis 300 µm aufweisen, wobei die elektrisch leitenden Fäden (22) gegenüber den nicht leitenden Fäden (24) um einen definierten Betrag nach außen vorstehen.

2. Verfahren nach Anspruch 1,
**dadurch gekennzeichnet,**
**dass** eine Fadenzahl des offenen Gewebes (20) in Kettrichtung und in Schussrichtung 40 bis 60 Fäden pro cm beträgt.

3. Verfahren nach Anspruch 1 oder 2,
**dadurch gekennzeichnet,**
**dass** die nicht-leitenden Fäden (24) mit einem thermoplastischen Olefin gebildet sind, welches teilweise aufschmilzt.

4. Verfahren nach einem der Ansprüche 1 bis 3,
**dadurch gekennzeichnet,**
**dass** die elektrisch leitenden Fäden (22) aus einem Metall oder einer Metalllegierung mit einer niedrigen Schmelz- oder Erweichungstemperatur, insbesondere von unter 200 °C, gebildet sind und teilweise aufschmilzt.

5. Verfahren nach einem der Ansprüche 2 bis 4,
**dadurch gekennzeichnet,**
**dass** Fäden (22, 24) unmittelbar in Kontakt mit der Oberfläche des Flächenelementes (12) kommen und beim Aufschmelzen sich eine Kontaktfläche der Fäden (22, 24) zur Oberfläche des Flächenelements (12) vergrößert.

6. Verfahren nach einem der Ansprüche 1 bis 5,
**dadurch gekennzeichnet,**
**dass** bei der Wärmebehandlung eine Temperatur von 250 °C, insbesondere von 200°C, nicht überschritten wird.

7. Verfahren nach einem der Ansprüche 1 bis 6,
**dadurch gekennzeichnet,**
**dass** nach dem Aufbringen des offenen Gewebes (20) eine Verbindungsmasse (14) auf das Flächenelement (12) laminiert wird.

8. Verfahren nach einem der Anspruch 1 bis 7,
**dadurch gekennzeichnet,**
**dass** als transparente Deckschicht (18) ein Glas auf das Flächenelement (12) aufgebracht wird.

9. Verfahren nach einem der Ansprüche 1 bis 8,
**dadurch gekennzeichnet,**
**dass** das offene Gewebe (20) eine Kontaktseite (26) aufweist, entlang welcher ein wesentlicher Teil der elektrischen leitfähigen Fäden (22) verläuft.

10. Verfahren nach einem der Ansprüche 1 bis 9,
**dadurch gekennzeichnet,**
**dass** in dem offenen Gewebe (20) die elektrisch leitenden Fäden (22) in Schuss- und/oder Kettrichtung verwebt werden.

11. Verfahren nach einem der Ansprüche 1 bis 10,
**dadurch gekennzeichnet,**
**dass** als photoelektrisch wirksames Flächenelement (12) eine Silizium-Heterostruktur-Solarzelle (SHJ-Solarzelle) vorgesehen ist.

12. Verfahren nach einem der Ansprüche 1 bis 11,
**dadurch gekennzeichnet,**
**dass** die Leiterbahnanordnung mit dem offenen Gewebe (20) einseitig oder zweiseitig auf das Flächenelement (12) aufgebracht wird.

13. Verfahren nach einem der Ansprüche 1 bis 12,
**dadurch gekennzeichnet,**
**dass** mehrere Flächenelemente (12) über ein oder mehrere Gewebe (20) zu einem photovoltaischen Modul (30) verbunden werden.

14. Verfahren nach einem der Ansprüche 1 bis 13,
**dadurch gekennzeichnet,**
**dass** die elektrisch leitenden Fäden (22) einen Abstand von 1mm bis 8mm zueinander aufweisen.

15. Photovoltaische Zelle und/oder Module mit mindestens einem photoelektrisch wirksamen Flächenelement (12) und mindestens einer Leiterbahnanordnung an mindestens einer Oberflächenseite des Flächenelements (12) hergestellt nach einem Verfahren nach einem der Ansprüche 1 bis 14,
wobei
- zum Bilden der Leiterbahnanordnung auf der mindestens einen Oberflächenseite des Flächenelementes (12) direkt ein offenes Gewebe (20) aufgebracht ist, welches aus elektrisch leitenden Fäden (12) und transparenten, elektrisch nicht-leitenden Fäden (24) gewebt ist, welche zumindest teilweise aufschmelzbar sind,
- die elektrische nicht leitenden Fäden mit einem thermoplastischen Polymermaterial gebildet sind, und
- nach dem Aufbringen des offenen Gewebes (20) die Fäden (22, 24) durch eine Wärmebehandlung teilweise aufgeschmolzen sind, wobei das offene Gewebe (20) fest mit dem Flächenelement (12) verbunden und daran fixiert ist,
**dadurch gekennzeichnet dass**,
- die elektrisch nicht leitenden Fäden (24) einen Durchmesser von 30 µm bis 70 µm und die elektrisch leitenden Fäden (22) einen Durchmesser von 70 µm bis 300 µm aufweisen, wobei die elektrisch leitenden Fäden (22) gegenüber den nicht leitenden Fäden (24) um einen definierten Betrag nach außen vorstehen.

## Claims

1. Method for producing a photovoltaic cell (10) with
- a photoelectrically active face element (12) and
- at least one conductor track arrangement on at least one surface side of the face element (12),
wherein
for the purpose of forming the conductor track arrangement an open fabric (20), which is woven of electrically conductive threads (22) and transparent, electrically non-conductive threads (24), is applied to the at least one surface side of the photoelectrically active face element (12), wherein the open fabric (20) is free from a planar coating, and
the open fabric (20) is formed at least partially with meltable threads (22, 24), wherein the electrically non-conductive threads (24) are formed with a thermoplastic polymer material,
wherein after application of the open fabric (20) a heat treatment takes place, in which the meltable threads (22, 24) are melted partially,
wherein the open fabric (20) with the partially melted threads (22, 24) is firmly connected to the face element (12) and fixed thereon, and on the fixed open fabric (20) a transparent cover layer (18) is applied,
**characterized in that**
the electrically non-conductive threads (24) have a diameter ranging from 30 µm to 70 µm and the electrically conductive threads (22) have a diameter ranging from 70 µm to 300 µm, wherein the electrically conductive threads (22) protrude outwards by a defined amount with respect to the non-conductive threads (24).

2. Method according to claim 1,
**characterized in that**
a thread count of the open fabric (20) amounts to 40 to 60 threads per cm in the warp direction and in the weft direction.

3. Method according to claim 1 or 2,
**characterized in that**
the non-conductive threads (24) are formed with a thermoplastic olefin that melts partially.

4. Method according to any one of claims 1 to 3,
**characterized in that**
the electrically conductive threads (22) are formed of a metal or a metal alloy with a low melting or softening temperature, in particular lying below 200 °C, and which melt partially.

5. Method according to any one of claims 2 to 4,
**characterized in that**
threads (22, 24) make direct contact with the surface of the face element (12) and during melting a contact face of the threads (22, 24) to the surface of the face element (12) increases.

6. Method according to any one of claims 1 to 5,
**characterized in that**
during heat treatment a temperature of 250 °C, in particular of 200 °C, is not exceeded.

7. Method according to any one of claims 1 to 6,
**characterized in that**
after application of the open fabric (20) a binding mass (14) is laminated onto the face element (12).

8. Method according to any one of claims 1 to 7,
**characterized in that**
as transparent cover layer (18) a glass is applied onto the face element (12).

9. Method according to any one of claims 1 to 8,
**characterized in that**
the open fabric (20) has a contact side (26), along which a substantial part of the electrically conductive threads (22) runs.

10. Method according to any one of claims 1 to 9,
**characterized in that**
in the open fabric (20) the electrically conductive threads (22) are interwoven in the weft and/or warp direction.

11. Method according to any one of claims 1 to 10,
**characterized in that**
as photoelectrically active face element (12) a silicon heterostructure solar cell (SHJ solar cell) is provided.

12. Method according to any one of claims 1 to 11,
**characterized in that**
the conductor track arrangement with the open fabric (20) is applied on one side or on two sides onto the face element (12).

13. Method according to any one of claims 1 to 12,
**characterized in that**
several face elements (12) are connected via one or several fabrics (20) to a photovoltaic module (30).

14. Method according to any one of claims 1 to 13,
**characterized in that**
the electrically conductive threads (22) have a distance of 1 mm to 8 mm to each other.

15. Photovoltaic cell and/or modules with
at least one photoelectrically active face element (12) and
at least one conductor track arrangement on at least one surface side of the face element (12) produced pursuant to a method according to any one of claims 1 to 14,
wherein
- for the purpose of forming the conductor track arrangement an open fabric (20), which is woven of electrically conductive threads (22) and transparent, electrically non-conductive threads (24) that are at least partially meltable, is applied directly to the at least one surface side of the face element (12),
- the electrically non-conductive threads are formed with a thermoplastic polymer material, and
- after application of the open fabric (20) the threads (22, 24) are melted partially through a heat treatment, wherein the open fabric (20) is firmly connected to the face element (12) and fixed thereon,
**characterized in that**
- the electrically non-conductive threads (24) have a diameter ranging from 30 µm to 70 µm and the electrically conductive threads (22) have a diameter ranging from 70 µm to 300 µm, wherein the electrically conductive threads (22) protrude outwards by a defined amount with respect to the non-conductive threads (24).

## Revendications

1. Procédé servant à fabriquer une cellule photovoltaïque (10) avec
- un élément de surface (12) actif de manière photoélectrique et
- au moins un ensemble formant piste conductrice au niveau d'au moins un côté de face supérieure de l'élément de surface (12),
dans lequel
pour former l'ensemble formant piste conductrice sur l'au moins un côté de face supérieure de l'élément de surface (12) actif de manière photoélectrique, un tissu (20) ouvert est appliqué, lequel est tissé à partir de fils conducteurs électriquement (22) et de fils transparents non conducteurs électriquement (24), dans lequel le tissu ouvert (20) est dépourvu d'un revêtement plan, et
le tissu ouvert (20) est formé au moins en partie avec des fils (22, 24) pouvant être fondus,
dans lequel les fils non conducteurs électriquement (24) sont formés avec un matériau polymère thermoplastique,
dans lequel après l'application du tissu ouvert (20), un traitement thermique est effectué, lors duquel les fils (22, 24) pouvant être fondus sont en partie fondus,
dans lequel le tissu ouvert (20) est relié de manière solidaire à l'élément de surface (12) avec les fils (22 ; 24) en partie fondus et y est fixé, et une couche de recouvrement (18) transparente est appliquée sur le tissu ouvert (20) fixé,
**caractérisé en ce**
**que** les fils non conducteurs électriquement (24) présentent un diamètre de 30 µm à 70 µm et les fils conducteurs électriquement (22) présentent un diamètre de 70 µm à 300 µm, dans lequel les fils conducteurs électriquement (22) font saillie vers l'extérieur d'une valeur définie par rapport aux fils non conducteurs (24).

2. Procédé selon la revendication 1,
**caractérisé en ce**
**qu'**un nombre de fils du tissu ouvert (20) est de 40 à 60 fils par cm dans le sens de chaîne et dans le sens de trame.

3. Procédé selon la revendication 1 ou 2,
**caractérisé en ce**
**que** les fils non conducteurs (24) sont formés avec une oléfine thermoplastique, qui fond en partie.

4. Procédé selon l'une quelconque des revendications 1 à 3,
**caractérisé en ce**
**que** les fils conducteurs électriquement (22) sont formés à partir d'un métal ou d'un alliage métallique avec une température de fusion ou de ramollissement basse, en particulier inférieure à 200 °C, et qui fond en partie.

5. Procédé selon l'une quelconque des revendications 2 à 4,
**caractérisé en ce**
**que** des fils (22, 24) viennent directement en contact avec la face supérieure de l'élément de surface (12) et une surface de contact des fils (22, 24) grandit en direction de la face supérieure de l'élément de surface (12) lors de la fusion.

6. Procédé selon l'une quelconque des revendications 1 à 5,
**caractérisé en ce**
**que** lors du traitement thermique, une température de 250 °C, en particulier de 200 °C, n'est pas dépassée.

7. Procédé selon l'une quelconque des revendications 1 à 6,
**caractérisé en ce**
**qu'**après l'application du tissu ouvert (20), une matière de liaison (14) est laminée sur l'élément de surface (12).

8. Procédé selon l'une quelconque des revendications 1 à 7,
**caractérisé en ce**
**qu'**un verre est appliqué sur l'élément de surface (12) en tant que couche de recouvrement (18) transparente.

9. Procédé selon l'une quelconque des revendications 1 à 8,
**caractérisé en ce**
**que** le tissu ouvert (20) présente un côté de contact (26), le long duquel une majeure partie des fils conducteurs électriquement (22) s'étend.

10. Procédé selon l'une quelconque des revendications 1 à 9,
**caractérisé en ce**
**que** dans le tissu ouvert (20), les fils conducteurs électriquement (22) sont tissés dans le sens de trame et/ou dans le sens de chaîne.

11. Procédé selon l'une quelconque des revendications 1 à 10,
**caractérisé en ce**
**qu'**une cellule solaire à hétérostructure de silicium (cellule solaire SHJ) est prévue en tant qu'élément de surface (12) actif de manière photoélectrique.

12. Procédé selon l'une quelconque des revendications 1 à 11,
**caractérisé en ce**
**que** l'ensemble formant piste conductrice est appliqué d'un côté ou sur les deux côtés avec le tissu ouvert (20) sur l'élément de surface (12).

13. Procédé selon l'une quelconque des revendications 1 à 12,
**caractérisé en ce**
**que** plusieurs éléments de surface (12) sont reliés par l'intermédiaire d'un ou de plusieurs tissus (20) en un module photovoltaïque (30).

14. Procédé selon l'une quelconque des revendications 1 à 13,
**caractérisé en ce**
**que** les fils conducteurs électriquement (22) présentent une distance de 1 mm à 8 mm les uns par rapport aux autres.

15. Cellule photovoltaïque et/ou modules avec au moins un élément de surface (12) actif de manière photoélectrique et au moins un ensemble formant piste conductrice au niveau d'au moins un côté de face supérieure de l'élément de surface (12) fabriquée et/ou fabriqués selon l'une quelconque des revendications 1 à 14,
dans laquelle et/ou lesquels,
- pour former l'ensemble formant piste conductrice est appliqué directement sur l'au moins un côté de face supérieure de l'élément de surface (12) un tissu ouvert (20), lequel est tissé à partir de fils conducteurs électriquement (12) et de fils transparents non conducteurs électriquement (24), lesquels peuvent être fondus au moins en partie,
- les fils électriques non conducteurs sont formés avec un matériau polymère thermoplastique, et
- après l'application du tissu ouvert (20), les fils (22, 24) sont en partie fondus par un traitement thermique,
dans laquelle et/ou lesquels le tissu ouvert (20) est relié de manière solidaire à l'élément de surface (12) et y est fixé,
**caractérisée** et/ou **caractérisés en ce que**
- les fils non conducteurs électriquement (24) présentent un diamètre de 30 µm à 70 µm et les fils conducteurs électriquement (22) présentent un diamètre de 70 µm à 300 µm, dans laquelle et/ou lesquels les fils conducteurs électriquement (22) font saillie vers l'extérieur d'une valeur définie par rapport aux fils non conducteurs (24).
